# FASCICULE DE BREVET EUROPEEN

(11) **EP 1 529 124 B1**
(45) Date de publication et mention de la délivrance du brevet: **01.04.2009**
(21) Numéro de dépôt: 03756536.3
(22) Date de dépôt: 07.08.2003
(51) Int. Cl.: C23C 14/10

(54) **PROCEDE D'OBTENTION D'UNE COUCHE MINCE DE SILICE FLUOREE STABILISEE, SUBSTRAT AINSI REVETU ET LENTILLE OPHTHALMIQUE AINSI OBTENUE**
VERFAHREN ZUR HERSTELLUNG EINER DÜNNEN SCHICHT VON STABILISIERTEM FLUORHALTIGEN SILIKA, SO BESCHICHTETES SUBSTRAT UND SO ERHALTENE OPHTHALMISCHE LINSE
METHOD FOR OBTAINING A THIN, STABILIZED FLUORINE-DOPED SILICA LAYER, RESULTING COATED SUBSTRAT AND OPHTHALMIC LENSOPTICS THUS OBTAINED

(30) Priorité: 08.08.2002 FR 0210110; 08.08.2002 FR 0210112
(43) Date de publication de la demande: 11.05.2005
(73) Titulaire: ESSILOR INTERNATIONAL COMPAGNIE GENERALE D'OPTIQUE, 94227 Charenton cédex (FR)
(72) Inventeur: SCHERER, Karin, F-94100 SAINT MAUR DES FOSSES (FR); LACAN, Pascale, F-75011 PARIS (FR); ROISIN, Philippe, F-91460 MARCOUSSIS (FR); BOSMANS, Richard, F-94880 Noiseau (FR)
(74) Mandataire: Michelet, Alain
(86) Numéro de dépôt international: PCT/FR2003/002487
(87) Numéro de publication internationale: WO 2004/016822

(56) Documents cités:
- EP-A- 0 975 017
- WO-A-02/11195
- PATENT ABSTRACTS OF JAPAN vol. 017, no. 654 (P-1653), 3 décembre 1993 (1993-12-03) & JP 05 215929 A (HITACHI CABLE LTD), 27 août 1993 (1993-08-27)
- PATENT ABSTRACTS OF JAPAN vol. 1999, no. 14, 22 décembre 1999 (1999-12-22) & JP 11 264903 A (CANON INC), 28 septembre 1999 (1999-09-28)
- LEE J H ET AL: "INHOMOGENEOUS REFRACTIVE INDEX OF SIOXFY THIN FILMS PREPARED BY IONBEAM ASSISTED DEPOSITION" SURFACE AND COATINGS TECHNOLOGY, ELSEVIER, AMSTERDAM, NL, vol. 128/129, juin 2000 (2000-06), pages 280-285, XP000997583 ISSN: 0257-8972

## Description

L'invention concerne d'une manière générale un procédé d'obtention d'une couche mince de silice dopée au fluor SiOₓF_{y}, stabilisée, une telle couche mince et leur application en optique ophtalmique, en particulier pour l'obtention de revêtement antireflets multicouches pour des lentilles ophtalmiques.

Les couches minces à base de silice SiO₂ sont largement utilisées en optique et plus particulièrement dans le domaine de l'optique ophtalmique. De telles couches minces à base de silice sont notamment utilisées dans les revêtements antireflets. Ces revêtements antireflets sont classiquement constitués d'un empilement multicouches de matériaux inorganiques. Ces empilements antireflets multicouches comportent généralement une ou plusieurs couche(s) ayant un bas indice de réfraction qui sont constituées par une couche mince à base de silice.

Les techniques de dépôt de telles couches minces à base de silice sont des plus diverses, mais le dépôt par évaporation sous vide est une des techniques les plus largement répandues. Ces couches minces à base de SiO₂ présentent des propriétés mécaniques tout à fait satisfaisantes et des indices de réfraction généralement de l'ordre de 1,48, pour une longueur d'onde voisine de 630 nm.

Cependant, afin de pouvoir améliorer les performances optiques de l'empilement antireflets et réaliser de nouveaux systèmes d'empilement antireflets, il serait souhaitable de pouvoir abaisser l'indice de réfraction de cette couche bas indice tout en conservant ses propriétés mécaniques satisfaisantes.

Pour résoudre ce problème technique, on a déjà proposé de réaliser des couches de silice SiO₂ poreuses, c'est-à-dire dans lesquelles on a emprisonné de l'air.

Malheureusement, outre des techniques de fabrication complexes, les couches ainsi obtenues présentent des propriétés mécaniques non satisfaisantes et dégradées par rapport à une couche mince de silice classique.

Par ailleurs, il est connu d'utiliser des couches minces de silice dopée au fluor dans d'autres domaines techniques, en particulier dans le domaine de la microélectronique. Dans ce cas, c'est la diminution de la constante diélectrique statique qui est recherchée.

Les couches obtenues le sont par dépôt chimique en phase vapeur assisté par plasma sur des pastilles de silicium.

Un des problèmes associés à l'utilisation de telles couches de silice dopée au fluor est la dégradation de leurs propriétés dans le temps.

La demande de brevet EP-0.975.017 décrit des semi-conducteurs comportant des couches mixtes SiO₂/SiOₓF_{y} revêtues d'une couche d'oxynitrure de silicium SiON, ayant pour but d'empêcher la diffusion du fluor hors de ces couches mixtes.

Cette demande de brevet mentionne en particulier que le dépôt d'une simple couche de SiO₂ sur des couches mixtes SiO₂/SiOₓF_{y}, ne permet pas d'empêcher la diffusion du fluor hors de ladite couche mixte, cette diffusion pouvant avoir lieu dans la couche de silice jusqu'à une profondeur de plusieurs centaines de nanomètres.

Bien évidemment, les propriétés de la couche de silice dopée au fluor s'en trouvent modifiées et des problèmes d'adhérence à l'interface des deux couches peuvent survenir.

La présente invention a donc pour objet un procédé d'obtention d'une couche mince de silice dopée au fluor SiOₓF_{y}, stabilisée, en particulier qui présente un indice de réfraction bas, stable au cours du temps et ayant des propriétés mécaniques au moins comparables aux couches de l'art antérieur.

L'invention a aussi pour objet un revêtement antireflets multicouches ayant au moins une couche de bas indice de réfraction constituée par une couche de silice dopée au fluor, stabilisée.

L'invention a enfin pour objet une lentille ophtalmique pourvue d'un revêtement antireflets tel que défini ci-dessus.

Selon l'invention l'obtention d'une couche mince de SiOₓF_{y} stabilisée, consiste à revêtir la couche mince de SiOₓF_{y} d'une couche protectrice de silice et/ou d'un oxyde métallique par dépôt en phase vapeur, sous assistance ionique.

Par assistance ionique on entend le bombardement de la couche de silice SiO₂ et/ou d'oxyde métallique, lors de sa formation, par un faisceau d'ions positifs formé à partir d'un gaz rare, d'oxygène, ou encore d'un mélange de deux ou plus de ces gaz.

Des exemples d'oxydes métalliques utilisables dans le cadre de la présente invention comme matériau pour la couché protectrice sont :
Al₂O₃ (Alumine), BaTiO₃, Bi₂O₃, B₂O₃, CeO₂, Cr₂O₃, Ga₂O₃, GeO₂, Fe₂O₃, HfO₂, In₂O₃, oxyde indium-étain, La₂O₃; MgO, Nd₂O₃, Nb₂O₅, Pr₂O₃, Sb₂O₃, Sc₂O₃, SnO₂, Ta₂O₅, TiO, TiO₂, TiO₃, WO₃ Y₂O₃, Yb₂O₃,ZnO, ZrO_{2.}

La couche protectrice préférée dans le cadre de l'invention est une couche de silice et/ou d'alumine, préférentiellement de silice SiO₂.

D'une manière générale, il est recommandé de déposer une faible épaisseur de couche protectrice ainsi qu'un matériau d'indice de réfraction relativement faible, assez proche de l'indice de la couche SiOₓF_{y}.

Avantageusement, la couche protectrice a une épaisseur de 2 à 40 nm, de préférence de 5 à 30 nm et mieux de 5 à 20 nm.

Si l'on utilise de très faibles épaisseurs pour la couche protectrice, il est possible d'utiliser une couche protectrice d'indice plus élevé.

Plus précisément, si la couche protectrice présente une épaisseur supérieure à 15 nm, l'indice du matériau constituant la couche protectrice est préférentiellement inférieure à 1,65.

Si la couche protectrice possède une épaisseur de 10 à 15 nm, il est possible d'utiliser comme matériau constituant la couche protectrice un matériau dont l'indice peut atteindre 2.

Cependant, et d'une manière générale, on préfère utiliser comme matériau constituant la couche protectrice, un matériau d'indice inférieur
ou égal à 1,65, plus spécialement d'indice inférieur ou égal à 1,6 et mieux encore d'indice inférieur ou égal à 1,55.

Dans un mode de réalisation optimal de l'invention, l'indice du matériau constituant la couche protectrice est inférieur ou égal à 1,50.

Les indices mentionnés ci-dessus sont les indices de réfraction à 550 nm de longueur-d'onde et à 25°C.

Il est tout à fait remarquable de constater qu'il est possible d'obtenir une excellente protection de la couche SiOₓF_{y} par des dépôts de silice et/ou d'oxyde métallique d'épaisseurs très faibles, généralement moins de 40 nm, et typiquement de l'ordre de 10 nm ou moins.

Du fait de la très faible épaisseur de la couche protectrice, celle-ci ne nuit pas aux propriétés optiques de la couche SiOₓF_{y} et il est donc possible d'utiliser pleinement le faible indice de réfraction de la couche SiOₓF_{y} pour obtenir des empilements antireflets dont les performances sont améliorées par rapport à ceux de l'art antérieur.

Les gaz utilisés pour l'assistance ionique sont de préférences l'argon, le xénon et l'oxygène, mieux l'argon et le xénon.

La couche d'oxyfluorure de silicium SiOₓF_{y} peut être obtenue par tout procédé connu.

Un procédé est décrit dans l'article « Characteristics of SiOₓF_{y} Thin Films Prepared by ion Beam Assisted Deposition (Caractéristiques des films minces SiOₓF_{y} préparés par dépôt assisté par faisceau d'ions) », F.J. Lee and C.K. Hwangbo décrit en particulier le dépôt de minces films de SiOₓF_{y} d'épaisseur environ 600 nm sur des substrats de verre et de silicium. La pression du vide de base est de 1,2 x 10⁻⁴ Pa et la température du substrat est d'environ 150°C. Le silicium est évaporé au moyen d'un faisceau d'électrons en présence d'oxygène dans la chambre et le dépôt d'oxyde de silicium est bombardé pendant sa formation par un faisceau d'ions polyfluorocarbonés formé au moyen d'un canon à ions à partir de gaz CF₄.

On peut également utiliser un procédé de dépôt avec co-assistance ionique. Ce procédé consiste à évaporer du silicium et/ou de l'oxyde de silicium et à déposer le silicium et/ou l'oxyde de silicium évaporé sur une surface d'un substrat pour former une couche d'oxyde de silicium, à bombarder, lors de sa formation, la couche d'oxyde de silicium par un faisceau d'ions positifs formés à partir d'un composé polyfluorocarboné ou d'un mélange de tels composés et à également bombarder la couche d'oxyde de silicium, lors de sa formation, avec un faisceau d'ions positifs formés à partir d'un gaz rare ou d'un mélange de gaz rares.

Pour former la couche d'oxyde de silicium, on peut utiliser un oxyde de silicium de formule SiOₓ avec x<2, SiO₂ ou un mélange SiOₓ/SiO₂. De préférence, on utilise SiO₂. Lorsqu'on utilise SiOx avec x<2 ou un mélange SiOₓ/SiO₂ il est nécessaire que le milieu ambiant renferme de l'oxygène O₂.

Le composé polyfluorocarboné peut être un composé perfluorocarboné linéaire, ramifié ou cyclique, de préférence linéaire ou cyclique.

Parmi les composés perfluorocarbonés linéaires, on peut citer CF₄, C₂F₆, C₃F₈ et C₄F₁₀ ; parmi les composés perfluorocarbonés cycliques, on peut citer C₃F₆ et C₄F₈ : le composé perfluorocarboné linéaire préféré est CF₄ et le composé cyclique C₄F₈.

On peut également utiliser un mélange des composés perfluorocarbonés.

Le composé polyfluorocarboné peut être également un hydrogénofluorocarbone, choisi de préférence parmi CHF₃, CH₂F₂, C₂F₄H₂. L'hydrogénofluorocarbone peut être lui aussi linéaire, ramifié ou cyclique.

Bien entendu, on peut utiliser un mélange de composés perfluorocarbonés et d'hydrogénofluorocarbones.

Le gaz rare est préférentiellement choisi parmi le xénon, le krypton et leurs mélanges. Le gaz rare préféré est le xénon. Le cas échéant, on peut utiliser de l'oxygène pour effectuer la co-assistance.

Lors du dépôt de la couche de silice dopée au fluor, le substrat est généralement à une température inférieure à 150°C, de préférence inférieure ou égale à 120°C et mieux encore de 30°C à 100°C.

Préférentiellement, la température du substrat varie de 50 à 90°C.

Le dépôt de la couche SiOₓF_{y} est mis en oeuvre dans une chambre vide à une pression de 10⁻² à 10⁻³ Pa. Eventuellement, du gaz oxygène peut être introduit dans la chambre à vide lors du dépôt de la couche.

Les couches d'oxyde de silicium dopé au fluor ont selon l'invention une épaisseur de 5 à 300 nm; de préférence de 30 à 160 nm, et mieux encore de 30 à 100 nm.

Les couches d'oxyde de silicium dopé au fluor obtenues ont un indice de réfraction n généralement allant de 1,38 à 1,44 (pour un rayonnement de longueur d'onde λ = 632,8 nm à 25°C).

De préférence, le dépôt de la couche SiOₓF_{y} se fait sans co-assistance ionique.

Les couches déposées sous assistance ionique avec des gaz rares ou l'oxygène présentent généralement en leur sein des contraintes importantes qui peuvent être préjudiciables à leurs propriétés mécaniques, et lorsque celles-ci font parties d'un empilement, aux propriétés globales de celui-ci.

Toutefois, dans le cas présent, les épaisseurs très faibles de la coche protectrice minimisent cet effet et il a été constaté que les empilements antireflets comprenant la couche SiOₓF_{y} stabilisée par la couche protectrice présentent des propriétés mécaniques tout à fait acceptables et comparables aux antireflets classiques.

L'invention concerne donc également des revêtements antireflets multicouches comprenant au moins une couche mince SiOₓF_{y} stabilisée selon l'invention.

Les antireflets classiques sont constitués d'un empilement monocouche de bas indice de réfraction (BI) ou multicouches ; par exemple bicouche haut indice (HI) / bas indice (BI), tricouche (BI/HI/BI), tétracouche (HI/BI/HI/BI) dont les indices et les épaisseurs sont choisies de façon appropriées, pour obtenir l'effet antireflets, comme cela est bien connu de l'homme de l'art.

Usuellement les couches bas indice sont à base de silice SiO₂.

Le matériau à haut indice de réfraction (HI) utilisé est un matériau dont l'indice de réfraction est supérieur ou égal à 1,55, préférentiellement supérieur ou égal à 1,60 et mieux encore supérieur ou égal à 1,65.

Le matériau à bas indice de réfraction (BI) utilisé a préférentiellement un indice de réfraction inférieur ou égal à 1,52, de préférence inférieur ou égal à 1,50.

D'une manière générale, les indices de réfraction auxquels il est fait également référence sont les indices à 550 nm de longueur d'onde et à 25°C, sauf mention contraire.

Les différentes couches de l'empilement anti-reflets peuvent être également réalisées par pulvérisation cathodique d'un métal ou de silicium suivie d'une oxydation du métal ou du silicium. L'utilisation de la pulvérisation cathodique permet avec un même dispositif de réaliser l'ensemble de couches de l'empilement et également de la couche SiOxFy en simplement changeant le métal pulvérisé et en introduisant un gaz précurseur de fluor dans l'oxygène lors de l'étape d'oxydation lorsque cela est nécessaire.

Les procédés et dispositifs pour la réalisation de couches d'oxydes métalliques et de dioxyde de silicium par pulvérisation cathodique sont bien connus. On peut citer le procédé commercial. Metamode^{®} de la société OCLI et l'appareil de pulvérisation Applied Vision RFX10.

Selon l'invention, on utilise comme couche bas indice la bicouche SiOₓF_{y}/SiO₂ et/ou oxyde métallique stabilisée.

Dans le cas de revêtement multicouches comportant deux couches bas indice ou plus, au moins une des couches bas indice est constituée par la bicouche SiOₓF_{y}/SiO₂ et/ou oxyde métallique selon l'invention: De préférence la bicouche SiOₓF_{y}/SiO₂ et/ou oxyde métallique selon l'invention est utilisée pour les couches bas indice en position supérieure dans l'empilement, c'est-à-dire les plus proches de l'air, car c'est dans ce cas que les améliorations antireflets sont les plus notables.

Dans le cas de revêtement antireflets comportant 4 couches HI/BI/HI/BI depuis la surface du substrat, les épaisseurs desdites couches varient de préférence dans l'ordre respectif suivant, depuis la surface du substrat:
HI : de 10 à 40 nm
BI : de 10 à 55 nm, préférentiellement de 10 à 45 nm
HI : de 30 à 155 nm, préférentiellement de 40 à 150 nm, et mieux de 120 à 150 nm
BI : couche SIOxFy de 70 à 110 nm
Couche protectrice : de 2 à 50 nm.

Les revêtements antireflets selon l'invention peuvent également comporter 6 couches, dans l'ordre respectif suivant, depuis la surface du substrat HI/BI/HI/BI/HI/BI.

Dans ce cas, les épaisseurs desdites couches varient de préférence dans l'ordre respectif suivant, depuis la surface du substrat :
HI : de 10 à 30nm
BI : de 10 à 55 nm, préférentiellement de 10 à 45 nm
HI : de 10 à 160 nm
BI : de 10 à 45 nm
HI de 35 à 170 nm
BI : 70 à 95 nm
couche protectrice : de 2 à 40 nm.

Les revêtements antireflets selon l'invention permettent d'obtenir des coefficients de réflexion Rrri (moyenne de la réflexion entre 400 et 700 nm) plus faibles que les revêtements de l'art antérieur, à empilement comparable.

Les revêtements antireflets selon l'invention présentent généralement un Rm inférieur à 0,6%, de préférence inférieur à 0,5%, et mieux inférieur ou égal à 0,4% (par face de substrat revêtu dudit revêtement anti-reflets),

Il est possible d'obtenir des revêtements anti-reflets dont le Rm est inférieur à 0,3%.

Les définitions des coefficients de réflexion (p) à une longueur d'onde donnée et Rm (moyenne de la réflexion entre 400 et 700 nm) sont connus de l'homme de l'art et sont mentionnés dans le document de norme ISO/WD 8980-4 (spécification et méthode de tests des revêtements anti-reflets).

La bicouche SiOₓF_{y}/SiO₂- et/ou oxyde métallique selon l'invention, ainsi que les revêtements antireflets comportant une telle bicouche, peuvent être déposés sur tout substrat approprié tels des substrats en silicium, verre minéral, verre organique, par exemple des lentilles en verre organique, ces substrats pouvant éventuellement être revêtus par des films antiabrasion, antichoc ou autres classiquement utilisés.

Bien évidemment, les revêtements antireflets selon l'invention peuvent comporter des revêtements permettant de modifier leurs propriétés de surface, tels que des revêtements antisalissures, hydrophobes. Il s'agit généralement de matériaux de type fluorosilane, de quelques nanomètres d'épaisseur.

La suite de la description se réfère aux figures annexées qui représentent respectivement :
Figure 1, une vue schématique d'un dispositif pour la mise en oeuvre du procédé de l'invention ;
Figure 2, une vue schématique de dessus du dispositif de la Figure 1.

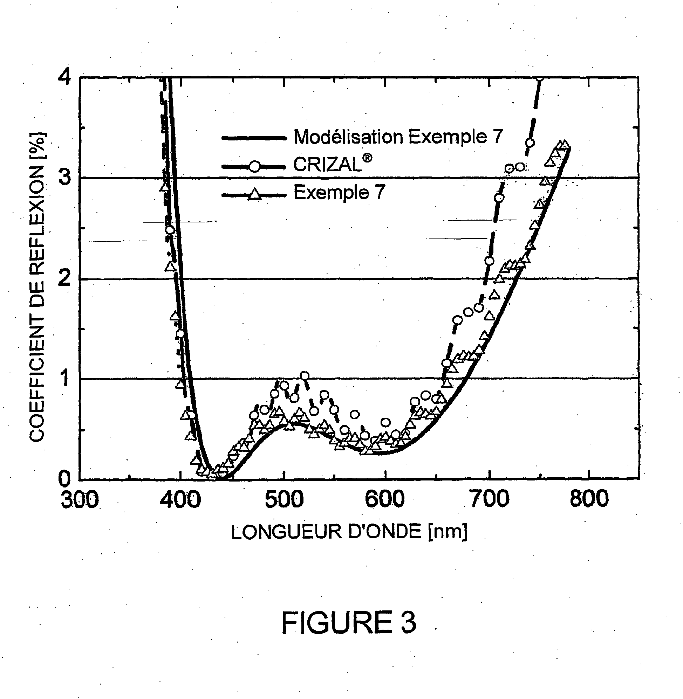

Figure 3, un graphe du coefficient de réflexion en fonction de la longueur d'onde après dépôt de revêtements antireflets selon l'invention et du commerce ;
Figure 4, un graphe du coefficient de réflexion en fonction de la longueur d'onde d'un revêtement antireflets selon l'invention et son évolution au cours du temps.
Figure 5, un schéma de principe du procédé Métamode^{®} appliqué au dépôt d'une couche d'oxyde métallique ; et
Figure 6, une vue de dessus de l'appareil de pulvérisation Applied Vision pour la mise en oeuvre du procédé Métamode^{®}.

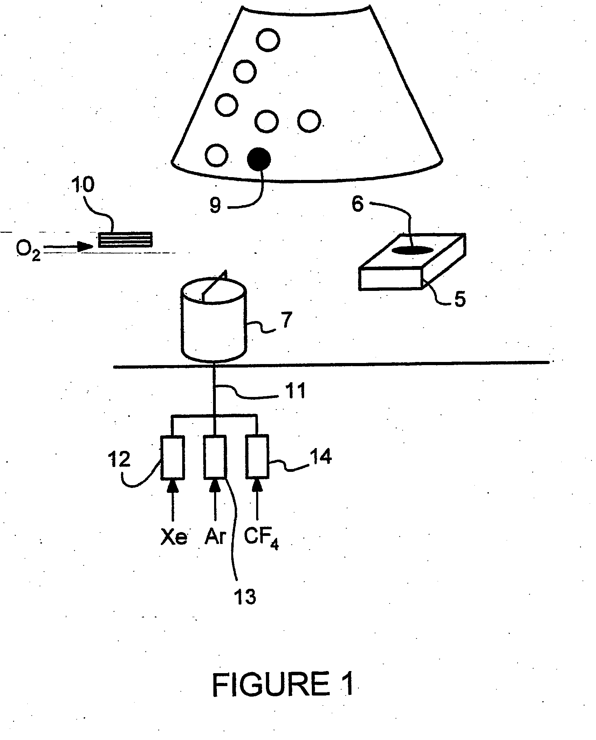

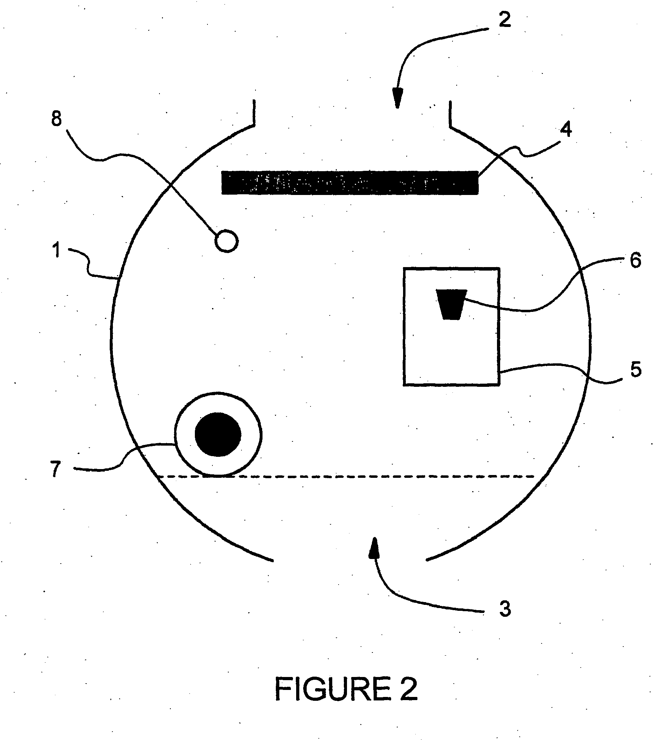

Le dispositif de dépôt assisté par faisceau d'ions de films minces des figures 1 et 2 est un dispositif classique. Ce dispositif comprend une chambre à vide 1 dont une première extrémité 2 est réunie à une ou plusieurs pompes à vide et l'autre extrémité opposée comporte une porte 3. Un piège froid 4 peut être disposé dans la chambre à proximité de l'extrémité 2 reliée aux pompes à vide. A l'intérieur de la chambre 1 ; se trouve un canon à électrons 5 comportant un creuset 6 destiné à contenir la silice à vaporiser. Les substrats à revêtir A sont disposés sur un support à proximité d'une microbalance à quartz 9. Une alimentation en gaz oxygène de la chambre 10 peut éventuellement être prévue La pression dans la chambre peut être mesurée au moyen d'une jauge de pression à cathode chaude 8. La conduite d'alimentation 11 du canon à ions 7 est reliée à trois dispositifs de commande d'alimentation en gaz permettant d'alimenter simultanément ou indépendamment le canon à ions avec les gaz de nature et débits voulus.

Dans le cas présent, la chambre à vide est une chambre Leybold Heraeus^{®} capable d'atteindre un vide de base de 5.10⁻⁵ Pa, le canon à ions est un canon MARK II^{®} Commonwealth, et le canon à électrons est un canon Leybold ESV^{®}.

Pour les dispositifs de commande de l'alimentation en gaz du canon à ions, on utilisé un dispositif de commande de débit massique BROOKS pour le gaz argon, lui-même commandé par le dispositif de commande MARK II^{®}. Pour l'alimentation en xénon et en composé polyfluorocarboné, on utilise des dispositifs de commande des débits massiques tels que le dispositif de commande multigaz MKS 647 B^{®} dans lequel la nature et le débit des gaz peuvent être programmés.

Le même dispositif peut être également utilisé pour un dépôt de SiOₓF_{y} sans co-assistance ionique.

Le dépôt sur les substrats de la couche de silice dopée au fluor, stabilisée, selon l'invention peut être mis en oeuvre de la façon suivante :

La chambre 1 est mise sous un vide de 2,10⁻³ Pa (mesuré avec la jauge à cathode chaude 8). Le canon à ions 7 est amorcé avec du gaz Ar, puis on introduit du gaz CF₄ (et éventuellement un gaz rare tel que Xe) au débit choisi, et le flux de Ar est interrompu (ou réglé au débit choisi). Les graines de silice (SiO₂) disposés dans le creuset 6 sont préchauffés par le canon à faisceau d'électrons 5. Lorsque du gaz oxygène est utilisé dans la chambre 1, il est introduit avec un débit réglé. A la fois, le canon à faisceau d'électrons 5 et le canon a ions 7 sont équipés d'un obturateur, et les deux obturateurs du canon à faisceau d'électrons et du canon à ions sont ouverts simultanément. L'épaisseur du dépôt est réglée par la microbalance à quartz 9 à proximité des substrats échantillons lorsque l'épaisseur voulue de la couche de SiOₓF_{y} est obtenue, les deux obturateurs sont fermés, l'émission du canon à faisceau d'électrons 5 est réduite, on introduit du gaz Ar ou Xe (ou O₂) au débit choisi dans le canon à ions 7, puis on arrête le flux de CF₄. Quand la tension d'anode et le courant d'anode du canon à ions 7 se sont stabilisés, les deux obturateurs sont ouverts, et on dépose ainsi une couche de SiO₂, avec assistance ionique (SiO₂ IAD). Quand l'épaisseur voulue de la couche SiO₂ IAD est obtenue, les deux obturateurs sont fermés, les canons à faisceau d'électrons 5 et à ions 7 sont coupés, l'alimentation des différents, gaz arrêtée, est le vide de la chambre 1 rompu.

Si on utilise un mélange Ar/CF₄ ou Xe/CF₄ ou O₂/CF₄ pour le dépôt de la couche SiOxFy : lorsque l'épaisseur voulue de la couche de SiOₓF_{y} est obtenues, on arrête le flux de CF₄, et on règle le débit choisi de Ar ou Xe ou O₂. De cette manière, on dépose une couche de SiO₂ IAD. Quand l'épaisseur voulue de la couche SiO₂ IAD est obtenue, les deux obturateurs sont fermés, les canons à faisceau d'électrons et à ions sont coupés, l'alimentation des différents gaz arrêtée, et le vide de la chambre rompu.

Bien évidemment, pour le dépôt de la couche SiOₓF_{y} on peut ne pas utiliser de co-assistance ionique. Dans ce cas on n'introduira pas de gaz rare dans le canon à ions 7.

Les exemples suivants illustrent la présente invention.

En procédant comme décrit précédemment, on a revêtu des échantillons plans de silicium avec des couches de silice dopée au fluor.

La vitesse de dépôt était constante et de 0,8 nm/s.

### Exemple comparatif A

Dans cet exemple comparatif, aucune couche protectrice n'est déposée. Les conditions de dépôt et l'épaisseur de la couche de SiOₓF_{y} sont indiquées dans le tableau ci-après.

| Condition de dépôt couche SiOₓF_{y} | | | | |
|---|---|---|---|---|
| Référence | Epaisseur SiOₓF_{y} [nm] | Débit CF₄ [cm³/minute] | Courant d'anode [A] | Tension d'anode [V] |
| Comparatif A | 230 | 3 | 0,7 | 100 |

### Exemple 1 à 6

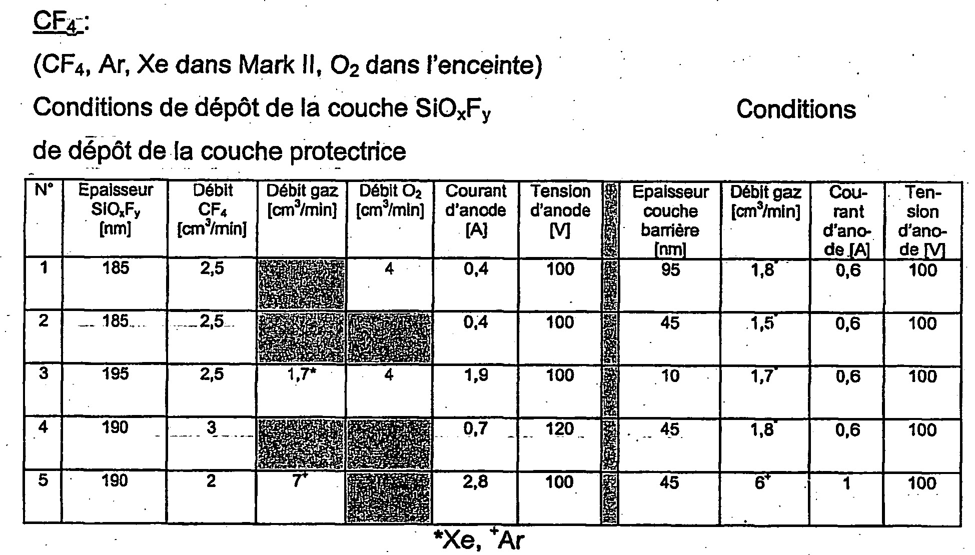

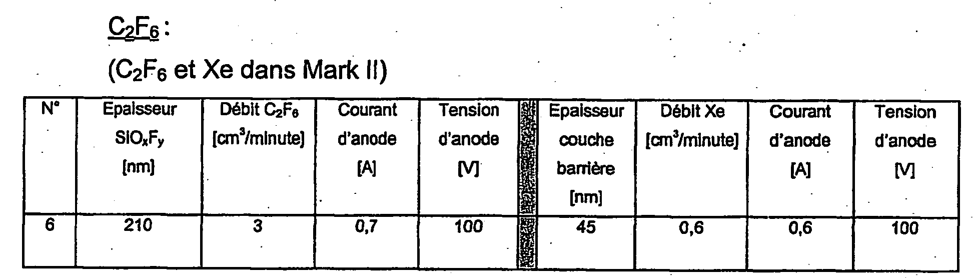

On a déterminé l'indice de réfraction à 25°C des couches SiOₓF_{y} obtenues pour λ = 632 nm, à partir des spectres ellipsométriques ;

On a déterminé également la présence ou l'absence d'eau dans la couche SiOₓF_{y}, par la présence ou non d'un pic entre 3400 et 3600 cm⁻¹ dans les spectres infrarouges de cette couche.

Les résultats sont mentionnés dans le tableau ci-après :

| | Comparatif A | | 1 | | 2 | | 3 | | 4 | | 5 | | 6 | |
|---|---|---|---|---|---|---|---|---|---|---|---|---|---|---|
| Temps après dépôt | n (SiOₓF_{y})@ 632 nm | Présence d'eau | n (SiOₓFy₎@ 632 nm | Présence d'eau | n (SiOₓF_{y})@ 632 nm | Présence d'eau | n (SiOₓF_{y} )@ 632 nm | Présence d'eau | n (SiOₓF_{y} ) @ 632 nm | Présence d'eau | n (SiOₓF_{y}) @ 632 nm | Présence d'eau | n (SiOₓF_{y})@ 632 nm | Présence d'eau |
| 10 min | 1,396 | non | | | | | | | | | | | | |
| 1 heure | 1,400 | | | non | | non | | non | | non | | non | 1,434 | non |
| 2 heures | 1,403 | | 1,411 | non | 1,417 | non | 1,421 | non | 1,385 | non | 1,404 | non | | |
| 3 jours | 1,440 | oui | 1,412 | non | 1,415 | non | 1,422 | non | 1,384 | non | 1,400 | non | | |
| 1 mois | 1,458 | oui | | | 1,418 | non | 1,421 | non | 1,383 | non | 1,394 | non | | |
| 3^{1/2} mois | | | | | | | | | | | | | 1,432 | non |
| 6 mois | | | 1,404 | | 1,416 | non | 1,424 | non | | | 1,400 | non | | |
| 8 mois | | | | | | | | | 1,388 | non | | | | |

Pour la couche de SiOₓF_{y} non protégée, l'indice augmente de 1,40 à 1,46 (indice de SiO₂) sur 1 mois, alors que pour les couches protégées selon l'invention l'indice ne change pas pendant au moins plusieurs mois.

### Exemple 7

L'exemple 7 est un exemple de revêtement antireflets qu'il est possible de réaliser avec les couches de SiOₓF_{y}/SiO₂ de l'invention.

Le substrat sur lequel a été réalisé ce revêtement antireflets est un substrat Orma® (matériau à base de diallyle carbonate de diéthylène glycol) revêtu d'un vernis antiabrasion du type hydrolysat d'époxysilane. Le vernis antiabrasion utilisé a été obtenu en faisant tomber goutte à goutte 80,5 partie de HCl 0,1 N dans une solution contenant 224 partie de γ-glycidoxypropyltriméthoxysilane et 120 parties de diméthyldiéthoxysilane. La solution hydrolysée est agitée 24 heures à température ambiante puis on ajoute 718 parties de silice colloïdale à 30% dans le méthanol, 15 parties d'acétylacétonate d'aluminium et 44 parties d'éthylcellosolve.

On ajoute une petite quantité d'agent tensioactif.

Le substrat revêtu du vernis est soumis à une précuisson de 15 minutes à 60°C puis est passé à l'étuve à 100°C pendant 3 heures.

Le revêtement de l'exemple 7 est constitué d'un empilement de couches, en partant de la couche supérieure jusqu'à la couche inférieure en contact avec le substrat, qui comprend :
- une couche SiO₂ IAD d'épaisseur 10 nm ;
- une couche SiOₓFy d'épaisseur 92 nm (n=1,42) ;
- une couche ZrO₂ d'épaisseur 42 nm ;
- une couche SiO₂ d'épaisseur 41 nm, et
- une couche ZrO₂ d'épaisseur 25 nm.

Ce revêtement a un Rm de 0,5 et un Rv (tel que défini dans ISO WD 8930-4 cité précédemment) de 0,4.

Les couches de SiOₓF_{y} et de SiO₂ IAD (couche barrière) ont été réalisées comme décrit précédemment avec les conditions opératoires suivantes.
Condition de dépôt de la couche SiOₓF_{y} Condition de dépôt de la couche protectrice

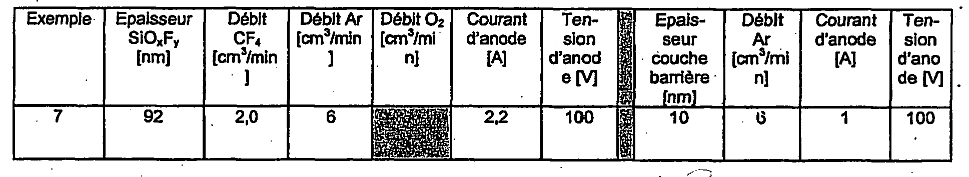

Les autres couches de l'empilement sont déposées en phase vapeur, dans des conditions classiques pour l'homme de l'art.

Sur l'empilement antireflets de l'exemple 7 on a pratiqué un test « nx10 coups ». le nombre de cycles que peut supporter l'empilement est de 12, au minimum.

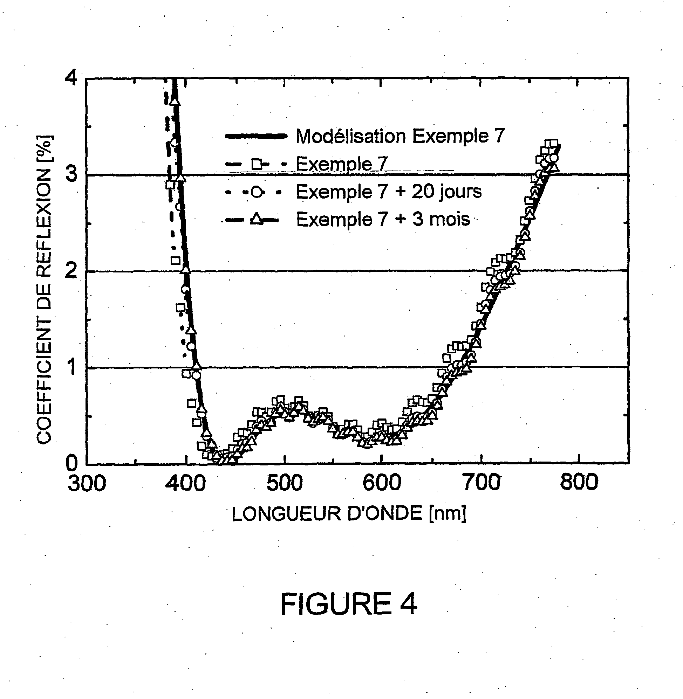

La figure 4 est un graphe du coefficient de réflexion de la surface du substrat en fonction de la longueur d'onde, après dépôt du revêtement de l'exemple 7 et d'un revêtement antireflets CRIZAL® du commerce formé sur un substrat identique.

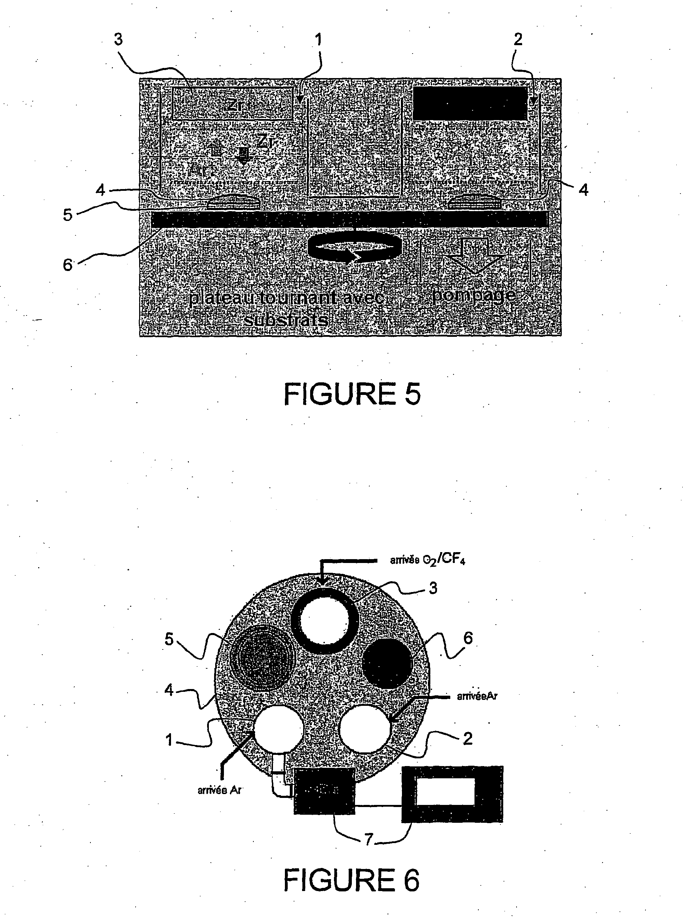

La figure 5 est un graphe du coefficient de réflexion en fonction de la longueur d'onde du revêtement de l'exemple 7, après dépôt, 20 jours après le dépôt et 3 mois après le dépôt.

Sur ces figures, la courbe en trait continu représente le coefficient de réflexion en fonction de la longueur d'onde d'un revêtement analogue à celui de l'exemple 7, mais obtenu par modélisation selon des techniques classiques connues de l'homme de l'art.

On voit que le revêtement antireflets selon l'invention présente une excellente stabilité dans le temps, comparable à cette des revêtements classiques.

### Descriptifs des méthodes de mesure et tests :

### Test nx10 coups

Le test nx10 coups est décrit dans la demande de brevet WO/9949097.

Succinctement, un tissu est appliqué à la surface du verre traité antireflets et on vient appuyer une gomme sur le tissu. La gomme et le substrat sont ensuite déplacés l'un par rapport à l'autre dans un mouvement de va-et-vient un cycle représente 10 mouvements de va-et-vient.

Le résultat représente le nombre de cycle que peut supporter un verre traité antireflets avant qu'apparaisse un défaut.

### Méthode de mesure de l'indice de réfraction :

D'une manière générale, l'indice de réfraction est mesuré par ellipsométrie sur des disques plans de silicium.

Pour la couche de l'exemple comparatif A, on a utilisé un ellipsomètre SENTECH SE 400^{®}, qui est calibré par la société SENTECH.

Les mesures ont été effectuées avec une longueur d'onde de 632,8 nm à un angle d'incidence de 70°. L'indice de réfraction et l'épaisseur sont calculés à partir de tan Ψ et cos Δ par une méthode de Newton en deux dimensions, en utilisant le modèle suivant :

| |
|---|
| SiOF (n,t) |
| SiO₂ natif (2 nm, n=1,457) |
| Si (n=3,881, k=0,020) |

Pour les couches de SiOₓF_{y} + couche protectrice (barrière), on utilise un ellipsomètre à angle variable SOPRA GESP 5 VASE^{®}. L'appareil est calibré selon la procédure conseillée par SOPRA. On mesure les spectres tan Ψ et cos Δ entre 300 et 850 nm, pour 3 angles d'incidence, 65°, 70° et 75°. Avec la méthode de régression selon Levenberg-Marquardt on fait une adaptation globale sur 3 spectres en utilisant le modèle suivant :

| |
|---|
| SiO₂ (t₁, a₁) |
| SiOF (t₂, A₂) |
| SiO₂ natif |
| Si |

La courbe de dispersion pour Si et pour SiO₂ (natif) provient des fichiers fournis par SOPRA. Pour SiOF et SiO₂ barrière, on suppose que la courbe de dispersion suit une loi de Cauchy (n=A+Bλ²=C/λ⁴, λ en µm), avec B=0.003, et C=0.

### Caractéristique des disques plans

Si {100}, 500 µm épaisseur, dopé p (B), résistivité > 100 Ωcm, poli, deux faces ; (pour les mesures IR) on découpe 6 échantillons dans une pastille de 50 mm ∅; →qqs (∼3)cm² par échantillon.

Les exemples qui suivent décrivent des empilements anti-réflets réalisables comportant une couche SiOxFy stabilisée par la couche protectrice (en couche barrière) selon l'invention ainsi que leurs performances optiques.

Les performances optiques (coefficients de réflexion) sont déterminés par le logiciel commercial FILM STAR DESIGN^{®} de FTG Software Associates - Princetown New Jersey et sont données ci-après.

Les performances optiques de ces empilements peuvent être également déterminées sans l'apport du logiciel ci-dessus, par simple calcul, en suivant les principes de base de l'optique des couches minces, connus de l'homme du métier et plus particulièrement exposés dans l'ouvrage « Thin film optical filters » Adam Higer Ltd - Bristol 1969 H.A. Mc Loed - Professor of Optical Sciences - University of Arizona - Tuckson.

Dans les exemples et tableaux qui suivent, les épaisseurs des couches sont, sauf indication contraire, mentionnées en nanomètres (nm).

De même, sauf indication contraire, les indices de réfraction sont les indices à 550 nm, 25°C.

Les matériaux utilisés dans les exemples sont :

| **Désignation du matériau** | **Nature du matériau** | **Indice de réfraction** |
|---|---|---|
| O | SiOxFy | 1,423 |
| N | SiOxFy | 1,388 |
| Q | SiO₂ | 1,473 |
| Z | ZrO₂ | 1,997 |
| A | Al₂O₃ | 1,646 |

### Exemples 8 à 10

Les exemples 8 à 10 illustrent trois empilements anti-reflets selon l'invention, déposés sur un verre ORMA^{®}, à base de CR39^{®}.

On utilise successivement comme couche protectrice une couche de silice, une couche d'alumine, une couche d'oxyde de zirconium, chacune de 10 nm d'épaisseur.

Les empilements sont décrits en partant de la couche inférieure, en contact avec le substrat jusqu'à la couche supérieure (BI - couche protectrice).

| | **Exemple 8** | | **Exemple 9** | | **Exemple 10** | |
|---|---|---|---|---|---|---|
| Nature Couche | Matériau | Epaisseur | Matériau | Epaisseur | Matériau | Epaisseur |
| HI | Z | 13 | Z | 13 | Z | 33 |
| BI | Q | 38 | Q | 38 | Q | 21 |
| HI | Z | 135 | Z | 135 | Z | 67 |
| BI | N | 82 | N | 76 | N | 68 |
| Couche protectrice | Q | 10 | A | 10 | Z | 10 |
| Rm (%) empilement | 0,21 | | 0,26 | | 0,53 | |

Le tableau ci-dessus illustre le fait qu'il est souhaitable d'utiliser une couche protectrice d'indice relativement faible, en particulier à base de SiO₂ pour obtenir les valeurs de Rm les plus faibles.

On voit cependant qu'il est possible d'obtenir de faibles valeurs de Rm (inférieures à 0,6%), même en utilisant une couche barrière d'indice élevé, dans la mesure où l'épaisseur de cette couche est faible (10 nm).

### Exemples 11 à 17

Ces exemples décrivent des revêtements ou empilements anti-reflets contenant 4 couches et une couche protectrice, dernière couche du dépôt.

| | | **Ex.11** | **Ex.12** | **Ex.13** | **Ex.14** | **Ex.15** | **Ex.16** | **Ex. 17** |
|---|---|---|---|---|---|---|---|---|
| Nature couche | Matériau | Epaisseurs (couche) (nm) | | | | | | |
| HI | Z | 40 | 10 | 13 | 14 | 19 | 25 | 26 |
| BI | Q | 16 | 31 | 45 | 25 | 38 | 39 | 10 |
| HI | Z | 64 | 126 | 137 | 117 | 150 | 40 | 94 |
| BI | O | 84 | 76 | 82 | 70 | 84 | 94 | 78 |
| Couche protectrice | Q | 10 | 10 | 10 | 10 | 10 | 10 | 10 |
| Rm (%) | | 0,5 | 0,4 | 0,42 | 0,49 | 0,47 | 0,47 | 0,45 |

### Exemples 18 à 24

Les exemples 18 à 24 illustrent les empilements anti-reflets du même type que ceux décrits dans les exemples 11 à 17, mais en utilisant comme couche bas indice, dernière couche déposée une couche de SiOxFy d'indice plus faible (couche N).

| | | **Ex.18** | **Ex.19** | **Ex.20** | **Ex.21** | **Ex.22** | **Ex.23** | **Ex.24** |
|---|---|---|---|---|---|---|---|---|
| Nature couche | Matériau | Epaisseurs (couches) (nm) | | | | | | |
| HI | Z | 40 | 10 | 10 | 20 | 12 | 19 | 26 |
| BI | Q | 18 | 20 | 55 | 37 | 29 | 50 | 10 |
| HI | Z | 59 | 127 | 136 | 155 | 123 | 30 | 95 |
| BI | N | 86 | 82 | 83 | 85 | 70 | 100 | 78 |
| Couche protectri ce | Q | 10 | 10 | 10 | 10 | 10 | 10 | 10 |
| Rm (%) | | 0,43 | 0,38 | 0,46 | 0,47 | 0,44 | 0,44 | 0,40 |

### Exemples 25 à 28

Dans les exemples 25 à 28, on fait varier l'épaisseur de la couche barrière.

| | | **Ex.25** | **Ex. 26** | **Ex.27** | **Ex.28** |
|---|---|---|---|---|---|
| Nature Couche | Matériau | Epaisseurs (couches) (nm) | | | |
| HI | Z | 13 | 13 | 13 | 13 |
| BI | Q | 38 | 38 | 38 | 37 |
| HI | Z | 134 | 135 | 135 | 135 |
| BI | N | 92 | 82 | 63 | 41 |
| Couche protectrice | Q | 2 | 10 | 25 | 45 |
| Rm (%) | | 0,2 | 0,21 | 0,27 | 0,44 |

Les exemples 29 à 32, dans la mesure où ils décrivent le dépôt d'une couche protectrice par pulvérisation cathodique suivi d'une oxydation, n'entrent pas dans le cadre de l'invention, mais sont donnés à titre illustratif.

### Exemples 29 à 31

Les exemples 29 à 31 décrivent des empilements anti-reflets comprenant 6 couches et une couche protectrice, dernière couche du dépôt.

| | | **Ex.29** | **Ex.30** | **Ex. 31** |
|---|---|---|---|---|
| Nature couche | Matériau | Epaisseurs (couches) (nm) | | |
| HI | Z | 16 | 10 | 10 |
| BI | Q | 33 | 66 | 10 |
| HI | Z | 157 | 23 | 10 |
| BI | Q | 17 | 41 | 11 |
| HI | Z | 150 | 139 | 109 |
| BI | O | 81 | 79 | 78 |
| Couche protectrice | Q | 10 | 10 | 10 |
| Rm (%) | | 0,29 | 0,40 | 0,39 |

Un autre mode de dépot de la couche protectrice d'oxyde métallique ou d'oxyde de silicium ou encore de la couche SiOxFy est un dépôt par pulvérisation cathodique ou « sputtering » suivi d'une étape d'oxydation ou d'oxydation en présence d'un gaz fluoré.

Préférentiellement, on effectue le dépôt de la couche d'oxyde métallique ou de silicium en effectuant successivement :
1) un dépôt d'une fine couche métallique ou de silicium par pulvérisation cathodique, et
2) une oxydation de la fine couche obtenue par de l'oxygène, préférentiellement sous forme de plasma réactif,
et en répétant ces opérations autant de fois que nécessaire pour obtenir l'épaisseur souhaitée de couche protectrice.

De préférence, les étapes 1) de dépôt et 2) d'oxydation sont effectuées dans deux zones de traitement localement distinctes.

La technique de pulvérisation de la fine couche métallique ou de silicium (étape 1)] est généralement une décharge en régime continu (de sputtering) et s'effectue sous vide.

Selon cette technique, la cible, ou cathode, composée du matériau (métal ou silicium) à déposer est alimentée par un générateur à courant continu de plusieurs kV. Le substrat à revêtir est disposé sur une anode, face à la cible refroidie par circulation d'eau. Après avoir établi le vide, on y introduit un gaz (le plus souvent de l'Argon) et on applique une tension négative sur la cible pour amorcer le plasma. Les ions positifs présents dans le plasma, accélérés vers la cible, projettent les atomes de la cible. L'impact des ions provoque aussi l'éjection de quelques électrons appelés électrons secondaires qui sont accélérés et rentrent en collision avec les atomes du gaz, ce qui permet d'entretenir le plasma. Les atomes de la cible une fois éjectés vont se déposer sur le substrat et ainsi créer une couche mince.

D'autres techniques de pulvérisation cathodique plus élaborées sont préférées pour la mise en oeuvre de l'invention.

Ainsi, préférentiellement, on utilise une anode alimentée séparément et sans contact avec le substrat.

Préférentiellement encore, on utilise une cathode magnétron. Ces cathodes sont des cathodes de type diode dans lesquelles un champ magnétique constitue un piège à électrons. Les courants électroniques se déplacent dans une direction qui est à la fois perpendiculaire au champ électrique et au champ magnétique selon des trajectoires qui sont cycloïdales. Ils acquièrent donc une énergie plus grande, et surtout parcourent des distances beaucoup plus grandes que dans la technique de diode continue. Les collisions ionisantes seront donc plus nombreuses, donc les densités de courant ionique sur la cible également plus importantes.

Les magnétrons sont plus particulièrement décrits dans l'ouvrage « Handbook of déposition technologies for films and coatings » Science, Technology and Applications, Rointan F. Bunshah 2nd Edition 1994 pp 280-292.

En ce qui concerne l'étape 2), comme indiqué précédemment, on utilise un plasma oxygène ou un mélange oxygène-gaz fluoré (par exemple CF₄). Le plasma oxygène dissocie les molécules en atomes d'oxygène qui sont très réactifs. La création d'oxygène réactifs favorise l'oxydation du substrat.

Un exemple de procédé de pulvérisation cathodique préféré est le procédé Métamode^{™} d'OCLI, qui combine l'ensemble des caractéristiques décrites ci-dessus, et dont le schéma de principe est représenté en figure 5.

En se référant à la figure 5, l'obtention d'une couche d'oxyde métallique par le procédé Métamode^{®} se fait dans deux chambres distinctes, à savoir une chambre de pulvérisation cathodique 1 ou le métal de la cathode 3 est pulvérisé sur la lentille 4 disposée sur un plateau 5 placé sur un plateau tournant 6. Le dépôt de la couche métallique se fait comme décrit ci-dessus.

Une fois la couche de métal déposée, par rotation du plateau 6 on amène la lentille 4 revêtue d'une couche de métal dans la chambre d'oxydation 2. Dans cette chambre 2, on crée un plasma d'oxygène (ou d'oxygène et d'un gaz fluoré tel que CF₄ sil on veut obtenir un oxyfluorure tel que SiOxFy) pour réaliser la couche d'oxyde métallique ou de silicium.

On répète le cycle de pulvérisation cathodique de métal/oxydation autant de fois que nécessaire à l'obtention de l'épaisseur voulue pour la couche finale d'oxyde métallique ou de SiO₂.

En variante, on peut répéter le cycle pulvérisation cathodique de métal/oxydation en changeant la nature du métal pulvérisé pour ainsi réaliser un empilement de couches d'oxydes métalliques de différentes natures, par exemple pour réaliser un empilement anti-reflets.

Le procédé Métamode^{®} peut être mis en oeuvre avec un appareil de pulvérisation tel que l'appareil Applied Vision RFX10^{®} représente schématiquement, en vue de dessous, à la figure 6.

Comme le montre la figure 6, l'appareil comprend deux chambres de pulvérisation cathodique 1, 2 munies chacune d'une arrivée de gaz inerte, par exemple de l'argon, et une chambre de réaction 3 (oxydation ou oxyfluoration) munie d'une arrivée de gaz (oxygène ou mélange d'oxygène et d'un gaz fluoré tel que CF₄). Les chambres sont reliées à un système de mise sous vide (non visible sur la figure 6). Les substrats à revêtir sont posés sur des plateaux et sont amenés sur la platine tournante 4 de l'appareil par l'intermédiaire d'un sas de chargement 5. L'appareil comporte également des moyens de contrôle du vide 6, tel qu'une jauge de Penning et des moyens de contrôle et de commande 7 des conditions de pulvérisation cathodique et d'oxydation.

Les substrats à revêtir, introduits par le sas de chargement sont amenés au moyen de la platine tournante 4 dans la chambre de pulvérisation cathodique 1 ou 2 où ils sont revêtus d'une couche de métal ou de silicium comme décrit ci-dessus. Après dépôt de la couche de métal ou de silicium, les substrats sont amenés dans la chambre de réaction 3 pour réaliser l'oxydation ou l'oxyfluoration de la couche de métal ou de silicium.

A la fin du traitement, les substrats revêtus sont déchargés par le sas 5.

### Exemple 32.

On a revêtu des substrats plan de silicium par le procédé Métamode^{®} avec :
1) une couche SiOF déposée par pulvérisation cathodique (sputtering)
2) une couche protectrice SiO₂ déposée également par pulvérisation cathodique.

### Condition de dépôt de couches SiOF + SiO2 barrière :

L'introduction du CF₄ se fait par la même ligne de gaz que l'oxygène

Puissance sur le magnétron avec le Silicium : 1.5 kW

Puissance plasma gun (plasma d'oxygène): 100 W

Dépôt de la couche SiOF : (durée 900 s ; => épaisseur 165 nm)
Débit Ar (pour pulvérisation de Si) : 12 sccm
Débit O₂ : 4 sccm
Débit CF₄ : 2 sccm
P : 3mTorr (0,4 Pa)

Dépôt de la couche barrière : (durée 90 s ; => épaisseur 15 nm)
Débit Ar (pour pulvérisation de Si) : 12 sccm
Débit O₂ : 4 sccm
Débit de CF₄ : -
P : 2,6mTorr (0,35 Pa)

Entre les deux couches, de préférence, on arrête le dépôt pendant ∼30 s pour assurer qu'il n'y a plus de CF₄ dans le système.

Résultat : indice de réfraction de la couche SiOF : = 1,415 à 632,8 nm, stable dans le temps.

## Revendications

1. Procédé d'obtention d'une couche mince de silice dopée au fluor SiOₓF_{y}, stabilisée, **caractérisé en ce qu'**il comprend la formation sur une couche d'oxyfluorure de silicium SiOₓF_{y} ayant une épaisseur de 5 à 300 nm, d'une couche protectrice de silice SiO₂ et/ou d'un oxyde métallique par dépôt en phase vapeur sous assistance ionique consistant à bombarder la couché en formation avec un faisceau d'ions positifs formés à partir d'un gaz rare, d'oxygène ou d'un mélange de deux ou plus de ces gaz.

2. Procédé selon la revendication 1, **caractérisé en ce que** la couche protectrice a une épaisseur de 2 à 40 nm, de préférence de 5 à 30 nm et mieux de 5 à 20 nm.

3. Procédé selon la revendication 1 ou 2, **caractérisé en ce que** les gaz utilisés pour l'assistance ionique sont choisis parmi l'argon, le xénon et l'oxygène, de préférénce l'argon et le xénon.

4. Procédé selon l'une quelconque des revendications précédentes, **caractérisé en ce que** la couche de SiOₓF_{y} a une épaisseur de 30 à 100 nm.

5. Procédé selon l'une quelconque des revendications précédentes, **caractérisé en ce que** l'indice de réfraction de la couche de SiOₓF_{y} est de 1,38 à 1,44, pour une longueur d'onde de 630 nm et à 25°C.

6. Revêtement antireflets multicouches formé sur un substrat, **caractérisé en ce qu'**il comprend au moins une couche mince, stabilisée, de silice dopée au fluor SiOₓF_{y} ayant une épaisseur de 5 à 300 nm revêtue d'un couche protectrice de silice et/ou d'un oxyde métallique obtenue par dépôt en phase vapeur sous assistance ionique consistant à bombarder la couche en formation à partir d'un faisceau d'ions positifs formés à partir d'un gaz rare, d'oxygène ou d'un mélange de deux ou plus de ces gaz.

7. Revêtement antireflets selon la revendication 6, **caractérisé en ce qu'**il comprend un empilement de couches haut indice(HI) et bas indice (BI), au moins une des couches bas indice étant une bicouche constituée par ladite couche mince, stabilisée, revêtue de ladite couche protectrice de silice et/ou d'un oxyde métallique.

8. Revêtement antireflets selon la revendication 7, **caractérisé en ce que** la couche bas indice bicouche constituée par ladite couche mince, stabilisée, revêtue de ladite couche protectrice de silice et/ou d'un oxyde métallique, est la couche supérieure de l'empilement.

9. Revêtement antireflets selon la revendication 8, **caractérisé en ce qu'**il comporte 4 couches dans l'ordre respectif suivant, depuis la surface du substrat : HI/BI/HIIBI.

10. Revêtement antireflets selon la revendication 9, **caractérisé en que** les épaisseurs desdites couches varient dans l'ordre respectif suivant, depuis la surface du substrat :
HI : de 10 à 40 nm
BI : de 10 à 55 nm, préférentiellement de 10 à 45 nm
HI : de 30 à 155 nm, préférentiellement de 40 à 150 nm, et mieux de 120 à 150 nm
BI : couche SIOₓF_{y} de 70 à 110 nm et couche protectrice de 2 à 50 nm.

11. Revêtement antireflets selon la revendication 8, **caractérisé en ce qu'**il comporte 6 couches, dans l'ordre respectif suivant, depuis la surface du substrat HIIBI/HI/BI/HIIBI.

12. Revêtement antireflets selon la revendication 11, **caractérisé en ce que** les épaisseurs desdites couches varient, dans l'ordre respectif suivant, depuis la surface du substrat :
HI : de 10à30nm
BI : de 10 à 55 nm, préférentiellement de 10 à 45 nm
HI : de 10 à 160 nm
BI : de 10 à 45 nm
HI de 35 à 170 nm
BI : couche SiOₓF_{y} de 70 à 95 nm et couche protectrice de 2 à 40 nm.

13. Revêtement antireflets selon l'une quelconque des revendications 6 à 12, **caractérisé en ce que** le substrat est un verre organique, éventuellement pourvu d'un revêtement anti-abrasion et/ou d'un revêtement anti-chocs.

14. Lentille ophtalmique en verre organique, **caractérisée en ce qu'**elle comprend un revêtement antireflets selon l'une quelconque des revendications 6 à 13.

## Claims

1. A method for obtaining a stabilized, SiOₓP_{y} fluorine-doped silica thin layer, **characterized in that** it comprises forming onto a 5 to 300 nm-thick, SiOₓF_{y} silicon oxyfluoride layer, a SiO₂ silica and/or metal oxide protective layer through ion beam-assisted vapor phase deposition, comprising bombarding the layer being formed with a beam of positive ions formed from a rare gas, from oxygen or from a mixture of two or more of such gases.

2. A method according to claim 1, **characterized in that** the protective layer is 2 to 40 nm thick, preferably 5 to 30 nm thick and more preferably 5 to 20 nm thick.

3. A method according to claim 1 or 2, **characterized in that** the gases being used for the ion beam assistance are selected amongst argon, xenon and oxygen, preferably argon and xenon.

4. A method according to any of preceding claims, **characterized in that** the SiOₓF_{y} layer is 30 to 100 nm thick.

5. A method according to any of preceding claims, **characterized in that** the SiOₓF_{y} layer refractive index ranges from 1.38 to 1.44, for a wavelength of 630 nm and at 25°C.

6. A multilayered antireflective coating formed onto a substrate, **characterized in that** it comprises at least one stabilized, 5 to 300 nm-thick, SiOₓF_{y} fluorine-doped silica thin layer, coated with a silica and/or metal oxide protective layer obtained through ion beam-assisted vapor phase deposition, comprising bombarding the layer being formed with a beam of positive ions formed from a rare gas, from oxygen or from a mixture of two or more of such gases.

7. An antireflective coating according to claim 6, **characterized in that** it comprises a stacking of high index (HI) and low index (LI) layers, at least one of the low index layers being a bilayer made of said stabilized thin layer coated with said silica and/or metal oxide protective layer.

8. An antireflective coating according to claim 7, **characterized in that** the bilayered low index layer made of said stabilized thin layer coated with said silica and/or metal oxide protective layer, is the top layer of the stacking.

9. An antireflective coating according to claim 8, **characterized in that** it comprises four layers in the following respective order, starting from the substrate surface: HI/LI/HI/LI.

10. An antireflective coating according to claim 9, **characterized in that** the thicknesses of said layers vary in the following respective order, starting from the substrate surface:
HI: from 10 to 40 nm
LI: from 10 to 55 nm, preferably from 10 to 45 nm
HI: from 30 to 155 nm, preferably from 40 to 150 nm, and more preferably from 120 to 150 nm
LI: from 70 to 110 nm for the SiOₓF_{y} layer and from 2 to 50 nm for the protective layer.

11. An antireflective coating according to claim 8, **characterized in that** it comprises six layers in the following respective order, starting from the substrate surface: HI/LI/HI/LI/HI/LI.

12. An antireflective coating according to claim 11, **characterized in that** the thicknesses of said layers vary in the following respective order, starting from the substrate surface:
HI: from 10 to 30 nm
LI: from 10 to 55 nm, preferably from 10 to 45 nm
HI: from 10 to 160 nm
LI: from 10 to 45 nm
HI: from 35 to 170 nm
LI: from 70 to 95 nm for the SiOₓF_{y} layer and from 2 to 40 nm for the protective layer.

13. An antireflective coating according to any of claims 6 to 13, **characterized in that** the substrate is an organic glass, optionally provided with an abrasion-resistant coating and/or with an impact-resistant coating.

14. An ophthahnic lens made in organic glass, **characterized in that** it comprises an antireflective coating according to any of claims 6 to 13.

## Patentansprüche

1. Verfahren zum Erhalten einer Fluor-stabilisierten Silizium-Oxid- SiOₓF_{y}-Dünnschicht, **dadurch gekennzeichnet, dass** es umfasst, die Bildung an einer Silizium-Fluor-Oxid- SiOₓF_{y}-Schicht mit einer Dicke von 5 bis 300nm einer Schutzschicht aus Silizium-Dioxid- SiO₂ und/oder einem metallischen Oxid, mittels Fällung in Dampfphase unter ionischer Mitwirkung, die darin bestehet, die in Bildung befindliche Schicht mit einem positiven Ionenstrahl zu beschießen, gebildet ausgehend von einem Edelgas, Sauerstoff oder einer Mischung von zweien oder mehreren dieser Gase.

2. Verfahren nach Anspruch 1, **dadurch gekennzeichnet, dass** die Schutzschicht eine Dicke hat von 2 bis 40nm, bevorzugt von 5 bis 30nm und insbesondere bevorzugt von 5 bis 20mm.

3. Verfahren nach Anspruch 1 oder 2, **dadurch gekennzeichnet, dass** die verwendeten Gase für die ionische Unterstützung gewählt sind unter Argon, Xenon und Sauerstoff, bevorzugt unter Argon und Xenon.

4. Verfahren nach einem der vorherigen Ansprüche, **dadurch gekennzeichnet, dass** die SiOₓF_{y}-Schicht eine Dicke hat von 30 bis 100nm.

5. Verfahren nach einem der vorangegangenen Ansprüche, **dadurch gekennzeichnet, dass** der Brechungsindex der SiOₓF_{y}-Schicht zwischen 1,38 und 1,44 für eine Wellenlänge von 630nm und bei 25°C ist.

6. Mehrschichtentspiegelungsbeschichtung, gebildet an einem Substrat, **dadurch gekennzeichnet, dass** sie umfasst, zumindest eine Fluor-stabilisierte Silizium-Oxid-SiOₓF_{y}- Dünnschicht mit einer Dicke 5 bis 300mm, beschichtet mit einer Schutzschicht aus Silizium-Dioxid und/oder einem metallischen Oxid, erhalten durch Fällung in Dampfphase unter ionischer Mitwirkung, darin bestehend die in Bildung befindliche Schicht mit einem positiven Ionenstrahl zu beschießen, ausgehend von einem Edelgas, Sauerstoff oder einer Mischung von zwei oder mehreren dieser Gase.

7. Entspiegelungsbeschichtung nach Anspruch 6, **dadurch gekennzeichnet, dass** sie einen Stapel umfasst an Hochindexsehichten (HI) und Niederindexschichten (BI), wobei zumindest eine der Niederindexschichten eine Doppelschicht ist, gebildet aus der stabilisierten Dünnschicht, beschichtet mit der Schutzschicht aus Silizium-Dioxid und/oder metallischem Oxid.

8. Entspiegelungsbeschichtung nach Anspruch 7, **dadurch gekennzeichnet, dass** die Niederindexdoppelschichtschicht, gebildet durch die stabilisierte dünne Schicht, die beschichtet ist mit der Schutzschicht aus Silizium-Dioxid und/oder einem metallischen Oxid die obere Schicht des Stapels ist.

9. Entspiegelungsbeschichtung nach Anspruch 8, **dadurch gekennzeichnet, dass** sie vier Schichten enthält in der jeweils nachfolgenden Anordnung, ausgehend von der Fläche des Substrats: HI/BI/HI/BI,

10. Entspiegelungsbeschichtung nach Anspruch 9, **dadurch gekennzeichnet, dass** die Dicken der Schichten variieren in der jeweiligen nachfolgenden Reihenfolge ausgehend von der Fläche des Substrates:
HI: von 10 bis 40nm
BI: von 10 bis 55nm, bevorzugt von 10 bis 45nm
HI: von 30 bis 155nm, bevorzugt von 40 bis 150nm und insbesondere bevorzugt von 120 bis 150nm
BI: SiOₓF_{y}-Schicht von 70 bis 110nm und Schutzschicht von 2 bis 50nm.

11. Entspiegelungsbeschichtung nach Anspruch 8, **dadurch gekennzeichnet, dass** sie sechs Schichten enthält, in der jeweiligen Reihenfolge wie nachfolgende angegeben, ausgehend von der Fläche des Substrates: HI/BI/HI/BI/HI/BI.

12. Entspiegelungsbeschichtung nach Anspruch 11, **dadurch gekennzeichnet, dass** die Dicken der Schichten variieren in der jeweiligen Reihenfolge wie nachfolgend angegeben, ausgehend von der Fläche Substrates:
HI: von 10 bis 30nm
BI: von 10 bis 55nm, bevorzugt von 10 bis 45nm
HI: von 10 bis 160nm
BI: von 10 bis 45nm
HI: von 35 bis 170nm
BI: SiOₓF_{y}-Schicht von 70 bis 95nm und Schutzschicht von 2 bis 40nm.

13. Entspiegelungsbeschichtung nach einem der Ansprüche 6 bis 12, **dadurch gekennzeichnet, dass** das Substrat eine organisches Glas ist, gegebenenfalls bereitgestellt mit einer antiabrassiven Beschichtung und/oder einer Stoßfestbeschichtung.

14. Ophthalmische Linse aus organischem Glas, **dadurch gekennzeichnet, dass** sie einer Entspiegelungsbeschichtung gemäß einem der Ansprüche 6 bis 13 umfasst.
